# EUROPEAN PATENT APPLICATION

(11) **EP 4 187 536 A1**
(43) Date of publication of application: **31.05.2023**
(21) Application number: 22205130.2
(22) Date of filing: 02.11.2022
(51) Int. Cl.: G11C 5/14, G06F 1/26, H03K 3/356, H03K 19/017

(54) **SEMICONDUCTOR DEVICE STRUCTURE FOR WIDE SUPPLY VOLTAGE RANGE**

(30) Priority: 02.11.2021 CN 202111291049; 30.12.2021 CN 202111649295; 10.01.2022 US 202217647475
(71) Applicant: Solomon Systech (Shenzhen) Limited, Shenzhen 518057 (CN)
(72) Inventor: DUNN, Pak-Kong, Shatin (HK); WU, Wen-Chi, 244 New Taipei (TW); LIN, Po Yen, Shatin (HK); YOU, Hai Bin, Shenzhen, GD518057 (CN)
(74) Representative: Modiano, Gabriella Diana

(57) **Abstract**

A level shifter circuit for translating input signal to output signal is disclosed. The level shifter includes an input stage and a latch stage. The latch stage comprises at least a transistor characterized in a substantially matched transconductance with the input stage for preventing a discrete realization of a voltage clamp circuit. The transistor is a semiconductor device including a source region having a source doping region and a drain region having a first doping region and a second doping region. The first doping region is doped with a first conductivity impurity. The second doping region is disposed around the first doping region so as to surround the first doping region, and is doped with a second conductivity impurity. The second doping region has a higher on-resistance than the first doping region, thereby a high resistive series path is created by the second doping region to mimic an embedded resistor.

## Description

### CROSS-REFERENCE TO RELATED APPLICATIONS

This application claims the benefit of China Invention Patent Application No. 202111291049.3, filed on November 02, 2021, China Invention Patent Application No. 202111649295.1, filed on December 30, 2021, and US Non-Provisional Patent Application No. 17/647,475, filed on 10 January 2022, which are incorporated by reference herein in its entirety.

### FIELD

The present invention relates to the field of semiconductor process technology, and in particular, to a layout structure of a semiconductor device for simplifying the circuit complexity in a circuit with a wide supply voltage range.

### LIST OF ABBREVIATIONS

- DMOS: double-diffused metal-oxide semiconductor
- EPI: epitaxy
- GND: ground
- I/O: input/output
- IC: integrated circuit
- ISO: isolation
- HVMOS: high-voltage metal-oxide semiconductor
- HVN: high-voltage NMOS
- HVNW: high-voltage N-Well
- HVP: high-voltage PMOS
- HVPW: high-voltage P-Well
- LDMOS: laterally-diffused metal-oxide semiconductor
- MOSFET: metal-oxide-semiconductor field-effect transistor
- NLDD: N-type lightly doped drain
- NMOS: N-channel metal-oxide semiconductor
- PMOS: P-channel metal-oxide semiconductor
- PWR: power
- RDSon: on-resistance
- STI: shallow trench isolation
- VBIAS: bias voltage

### BACKGROUND

MOSFET is widely used in different digital circuits and analog circuits for various fields of applications. It can achieve a high breakdown voltage and a large current capacity, which can be integrated into a control circuit, a logic block, a power switch, and other circuits. In order to achieve the desired performance, reducing the RDSon during the conduction state of the MOSFET is one of the design considerations for minimizing the conduction loss, thereby the power consumption and delay can be lowered.

Particularly in a multi-voltage system, level shifters are commonly used for converting a signal from one voltage domain to another voltage domain. Circuitry may be configured to operate an IC with a smaller voltage for power conservation, and drive a higher output voltage for controlling an external device such as another IC. For instance, the core logic circuit of the IC uses 1.2V and 0V for representing logic 1 and 0, and the I/O circuit uses 5V and 0V for representing logic 1 and logic 0. The level shifter can be disposed between the core logic circuit and the I/O circuits for translating a signal from the core logic circuit to another signal for the I/O circuit. In certain applications, the level shifter has a wide supply voltage range. However, the highly repeated level shifters may suffer from the problem of racing at transition as a result of the voltage range. Hence, the level shifters are required to be modified for handling such a wide supply voltage range, and to compensate for any transconductance variation.

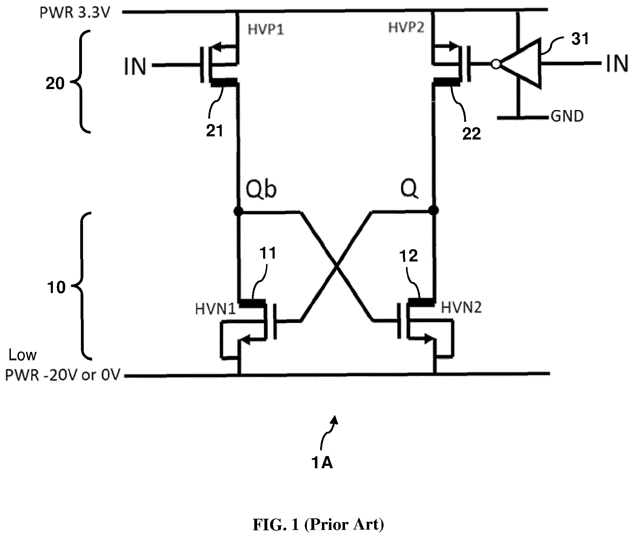

With reference to the ideal case of the level shifter **1A,** as illustrated in FIG. **1****,** the conventional level shifter **1A** comprises an input stage **20** (HVP1 **21** and HVP2 **22**) and a latch stage **10** having cross-coupled NMOS transistors (HVN1 **11** and HVN2 **12**)**.** The operation of the conventional level shifter **1A** will be described below for the sake of explaining the problem encountered when the supply voltage range is wide.

When the input signal **IN** is in a logic low state, such as ground, the HVP1 **21** turns on and conducts. The same input signal **IN** is inverted by the inverter **31** and so the HVP2 **22** is turned off. This pulls the Qb node at the drain of the HVP1 **21** to PWR (such as 3.3V). The Qb node is also connected to the gate of the HVN2 **12.** The transition of Qb node can therefore turn on HVN2 **12,** and pulls the Q node to low PWR (such as -20V or 0V). As a result, HVN1 **11** is turned off by the Q node. The same concept can also be applied when the input signal **IN** is in a logic high state. The conventional level shifter **1A** can achieve a very low quiescent current consumption and the output delay can also be minimized. The conventional level shifter **1A** is characterized in a wide supply voltage range which, as demonstrated in the illustrated embodiments, can translate an input voltage from a low-voltage domain to an output voltage from a high-voltage domain (5 to 20 times of the input voltage level) that is suitable for the desired operation. For example, the input voltage may be in the range of 3.3V, and the output voltage across Q node and Qb node is in the range of 23.3V.

Nonetheless, the level shifter **1A** of FIG. **1** is an ideal condition without considering the actual physical characteristics when implementing the circuit in silicon. In a practical case, the difference of the driving voltage between the input stage **20** (HVP1 **21** and HVP2 **22**) and the latch stage **10** having cross-coupled NMOS transistors (HVN1 **11** and HVN2 **12**) will result in a racing condition at transition. The transconductance increases when the gate voltage of the transistor increases. The HVP1 **21** and HVP2 **22** are required to have an increased area in order to match with the NMOS transistors HVN1 **11**, HVN2 **12**.

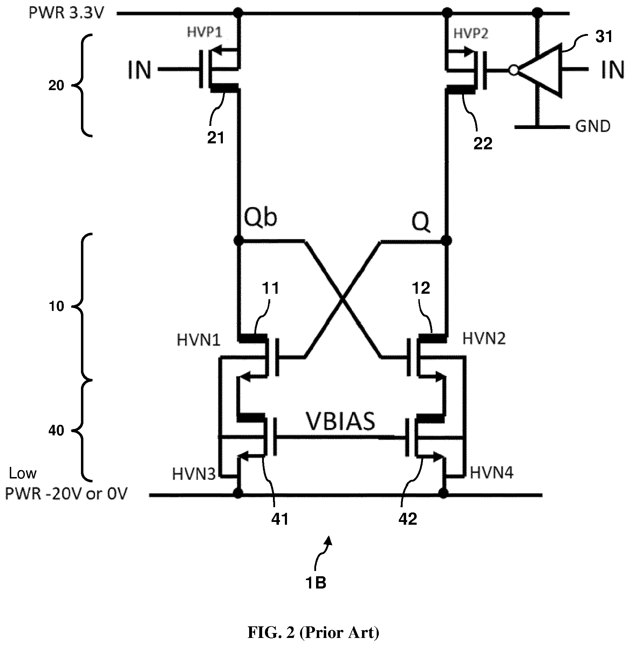

There are a few approaches to solve the problem as highlighted above. Referring to FIG. 2, there is provided an alternative level shifter **1B** commonly used for preventing the racing condition at transition. The HVN1 **11** and HVN2 **12** have low driving by means of the addition of two current sources formed by HVN3 **41** and HVN4 **42** as voltage clamp circuit **40** for reducing the RDSon, which are respectively connected in series with HVN1 **11** and HVN2 **12.** These voltages on the two additional NMOS transistors HVN3 **41** and HVN4 **42** are controlled by their conductivity. The drawbacks of this alternative level shifter **1B** are the need for additional transistors and the VBIAS reference circuit for compensating the output voltage variation, which undesirably and inevitably requires a larger die size.

Accordingly, there is a need in the art for a structure that seeks to address at least some of the above problems identified in a circuit with a wide supply voltage range. Furthermore, other desirable features and characteristics will become apparent from the subsequent detailed description and the appended claims, taken in conjunction with the accompanying drawings and this background of the disclosure.

### SUMMARY

Provided herein is a layout structure of a semiconductor device for simplifying the circuit complexity in a circuit with a wide supply voltage range. It is an objective of the present disclosure to provide a structure that can prevent racing at transition without the need to include complexity circuity to the level shifter.

In accordance with the embodiments of the present disclosure, a level shifter circuit for translating input signal of a first voltage domain to output signal of a second voltage domain is disclosed. The level shifter circuit includes an input stage, and a latch stage. The input stage receives the input signal. The latch stage couples to the input stage for storing a logic state associated with the input signal and generating the output signal. The latch stage comprises at least a transistor characterized in a substantially matched transconductance with the input stage for preventing a discrete realization of a voltage clamp circuit or a significant increase in transistor area. The transistor is a semiconductor device including a source region having a source doping region formed below a source terminal, and a drain region having a first doping region and a second doping region, both formed below a drain terminal. The first doping region is doped with a first conductivity impurity. The second doping region is disposed around the first doping region so as to surround the first doping region, and is doped with a second conductivity impurity. The second doping region has a higher on-resistance than the first doping region, thereby a high resistive series path is created by the second doping region to mimic an embedded resistor.

In accordance with a further aspect of the present disclosure, the drain region is disposed in a first well region of a first conductive type, and the source region is disposed in a second well region of a second conductive type different from the first well region.

In accordance with the first aspect of the present disclosure, the second doping region has a lower doping concentration of the first conductive type than the first doping region. The first well region is a high-voltage N-well and the second well region is a high-voltage P-well; and the first doping region is a heavily doped N+ region, and the second doping region is a lightly doped N+ region. Alternatively, the first well region is a high-voltage P-well and the second well region is a high-voltage N-well, and the first doping region is a heavily doped P+ region, and the second doping region is a lightly doped P+ region.

In accordance with the second aspect of the present disclosure, the first doping region has a doping of the first conductive type; and the second doping region has a doping of the second conductive type. The first well region is a high-voltage N-well and the second well region is a high-voltage P-well; and the first doping region is an N+ region, and the second doping region is a P+ region. Alternatively, the first well region is a high-voltage P-well and the second well region is a high-voltage N-well; and the first doping region is a P+ region, and the second doping region is an N+ region.

In accordance with a further aspect of the present disclosure, the second doping region is formed by plural longitudinal strips, plural lateral strips, or a checkerboard arrangement of the second conductive type with a higher doping concentration than the first well region.

In accordance with a further aspect of the present disclosure, the drain region is disposed in a first well region of the first conductive type, and the source region is disposed in a second well region of the first conductive type, thereby the transistor has a symmetrical structure of the source region and the drain region.

In accordance with a further aspect of the present disclosure, the drain terminal, the source terminal, or both the drain and source terminals have reduced active areas for reducing an effective channel width, thereby the high resistive series path has a higher resistance.

In accordance with a further aspect of the present disclosure, the semiconductor device further comprises a gate electrode disposed on a gate insulating layer for forming a conduction channel between the source region and the drain region, and wherein the high resistive series path is formed between the first doping region and the conduction channel.

In accordance with a further aspect of the present disclosure, the semiconductor device further comprises a shallow trench isolation region adjacent to the second doping region and at least partially under the gate insulating layer.

In accordance with a further aspect of the present disclosure, the latch stage comprises a pair of cross-coupled transistors.

This Summary is provided to introduce a selection of concepts in simplified forms that are further described below in the Detailed Description. This Summary is not intended to identify key features or essential features of the claimed subject matter, nor is it intended to be used as an aid in determining the scope of the claimed subject matter. Other aspects and advantages of the present invention are disclosed as illustrated by the embodiments hereinafter.

### BRIEF DESCRIPTION OF THE DRAWINGS

The appended drawings contain figures to further illustrate and clarify the above and other aspects, advantages, and features of the present disclosure. It will be appreciated that these drawings depict only certain embodiments of the present disclosure and are not intended to limit its scope. It will also be appreciated that these drawings are illustrated for simplicity and clarity and have not necessarily been depicted to scale. The present disclosure will now be described and explained with additional specificity and detail through the use of the accompanying drawings in which:
FIG. **1** depicts an ideal case of a level shifter;
FIG. **2** depicts a practical case of a level shifter commonly used for preventing the racing condition at transition;
FIG. **3** depicts a circuit diagram of a level shifter having an embedded resistor at the drain of the NMOS transistor in accordance with certain embodiments of the present disclosure;
FIG. **4** depicts a circuit diagram of a level shifter having an embedded resistor at the drain of the PMOS transistor in accordance with another embodiment of the present disclosure;
FIG. **5** depicts a cross-sectional view of the layout structure of the NMOS transistor in an asymmetric structure for the level shifter of FIG. **3** in accordance with certain embodiments of the present disclosure;
FIG. **6** depicts a cross-sectional view of the layout structure of the NMOS transistor in a symmetric structure for the level shifter of FIG. **3** in accordance with another embodiment of the present disclosure;
FIG. **7** depicts a cross-sectional view of the layout structure of the NMOS transistor in an asymmetric structure for the level shifter of FIG. **3** in accordance with another embodiment of the present disclosure;
FIG. **8** depicts a top view of the first layout structure with longitudinal strip-shaped implantation for increasing the embedded resistance in accordance with another embodiment of the present disclosure;
FIG. **9** depicts a top view of the second layout structure with lateral strip-shaped implantation for increasing the embedded resistance in accordance with another embodiment of the present disclosure;
FIG. **10** depicts a top view of the third layout structure with checkerboard implantation for increasing the embedded resistance in accordance with another embodiment of the present disclosure; and
FIG. **11** depicts a top view of the fourth layout structure for reducing the active area in accordance with another embodiment of the present disclosure.

### DETAILED DESCRIPTION

The present disclosure generally relates to a semiconductor process device and the configuration thereof. More specifically, but without limitation, the present disclosure relates to a layout structure of a semiconductor device for simplifying the circuit complexity in a circuit with a wide supply voltage range. The semiconductor process device may be implemented using MOSFET, for example, PMOS, NMOS, or HVMOS (DMOS and LDMOS) transistors. An objective of the present disclosure is to avoid the racing condition at transition in a circuit having a wide supply voltage range by modifying the processing structure and/or the layout design.

The following detailed description is merely exemplary in nature and is not intended to limit the disclosure or its application and/or uses. It should be appreciated that a vast number of variations exist. The detailed description will enable those of ordinary skilled in the art to implement an exemplary embodiment of the present disclosure without undue experimentation, and it is understood that various changes or modifications may be made in the function and structure described in the exemplary embodiment without departing from the scope of the present disclosure as set forth in the appended claims.

The use of the terms "a", "an", "the", and similar referents in the context of describing the invention (especially in the context of the following claims) are to be construed to cover both the singular and the plural, unless otherwise indicated herein or clearly contradicted by context. The terms "comprising", "having", and "including" are to be construed as open-ended terms (i.e., meaning "including, but not limited to,") unless otherwise noted. The use of any and all examples, or exemplary language (e.g., "such as") provided herein, is intended merely to illuminate the invention better and does not pose a limitation on the scope of the invention unless otherwise claimed. No language in the specification should be construed as indicating any non-claimed element as essential to the practice of the invention.

The benefits, advantages, solutions to problems, and any element(s) that may cause any benefit, advantage, or solution to occur or become more pronounced are not to be construed as critical, required, or essential features or elements of any or all of the claims. The invention is defined solely by the appended claims including any amendments made during the pendency of this application and all equivalents of those claims as issued.

As used herein throughout the specification, notations N⁺, N, P⁺, and P indicate relative levels of impurity concentration in each conductivity type. That is, N+ indicates an N-type impurity concentration higher than that of N, and P+ indicates a P-type impurity concentration higher than that of P. For simplicity and clarity, an N+-type is sometimes referred to as an N-type, and a P+-type is sometimes referred to as a P-type.

These examples and other embodiments described in the present disclosure may be implemented in one single die or in separate dies. Alternatively, the invention can also be implemented using more than one die stack, or embedded in an integrated circuit with intellectual property blocks. Various modes can be implemented according to the examples described in the present disclosure. An ordinary skilled person in the art will easily understand after reading the present disclosure, additional or other benefits can be achieved through various examples.

Unless otherwise defined, all terms (including technical and scientific terms) used in the embodiments of the present invention have the same meaning as commonly understood by an ordinary skilled person in the art to which the present invention belongs.

The present disclosure discusses a specific context of a level shifter, which is a circuit that is highly repeated in an IC device. By minimizing the size of the level shifter, the die size of the IC device can be significantly reduced. The invention may be applied, however, to other types of circuits and systems, for instance, in a circuit for a multi-voltage system comprising a first system block and a second system block, the present disclosure can be applied to a voltage switching module for transmitting a signal from the first system block operating at a first voltage level to the second system block operating at a second voltage level. Another example is a discrete electronic component having a data input module, a data output module, and a voltage switching module comprising a lever shifter for translating a signal from the data input module to the data output module, wherein the voltage switching module comprises a level shifter for translating an input signal of a first voltage domain from the data input module to an output signal of a second voltage domain for the data output module.

As shown in FIG. **1** and FIG. **2****,** the conventional level shifter **1A**, **1B,** particularly for a multi-voltage system, has a race condition during the transition when operating with a wide supply voltage range. The level shifter is generally used for translating an input signal of a first voltage domain to an output signal of a second voltage domain. For example, the input voltage has a first voltage domain limited by 3.3V, while the output voltage has a second voltage domain limited by 23.3V. This requires a relatively significant increase in the low-voltage conversion area in order to avoid the race condition. This can be done by increasing the transistor size of the PMOS transistors HVP1 **21,** HVP2 **22** at the input stage **20** to match with the NMOS transistors at the latch stage **10.** The present invention provides a device modification for increasing the RDSon of the first and second high-voltage transistors HVN1 **11** and HVN2 **12,** which is substantially equivalent to adding an embedded resistor in series to the drain. Therefore, the novel structure is optimized to avoid the race condition without significantly increasing the die size and cost.

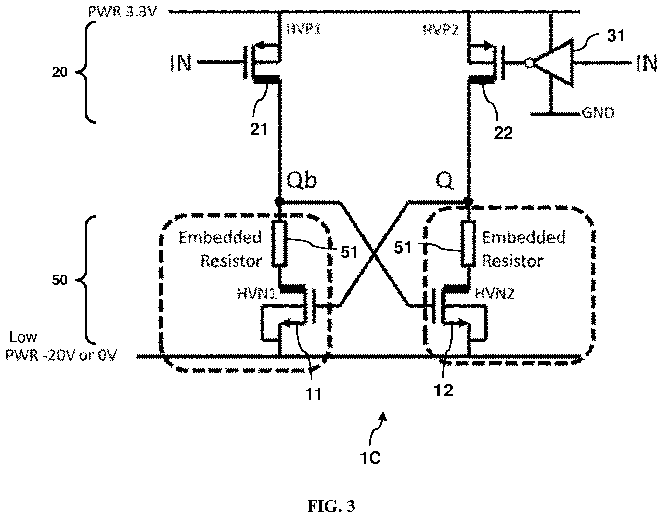

FIG. **3** shows a circuit diagram of a level shifter **1C** having an embedded resistor at the drain of the NMOS transistor for simplifying the circuit complexity of a circuit with a wide supply voltage range, thereby the die area can be minimized. The level shifter **1C** is configured to translate an input voltage from a first voltage domain to an output voltage from a second voltage domain that is suitable for the desired operation. For example, the input voltage may be in the range of 3.3V, and the output voltage across Q node and Qb node is in the range of 23.3V. The second voltage domain may be a few times or over 20 times larger than the first voltage domain. The level shifter **1C** contains an input stage **20** made of PMOS transistors **21, 22** and inverter **31,** and a latch stage **50.** The input stage **20** receives the input signal **IN** at the gate of HVP1 **21,** and the gate of the HVP2 **22** is driven by the inverted input signal **IN,** which is inverted by the inverter **31.** The inverter **31** is referenced to a high voltage of PWR and a low voltage of GND. The input signal **IN** is also ranged between PWR and GND, which is the first voltage domain. The drains of the two PMOS transistors (HVP1 **21,** HVP2 **22**) are respectively electrically connected to drive a pair of cross-coupled NMOS transistors (HVN1 **11** and HVN2 **12**) at the latch stage **50.** When the variation of the output voltage (second voltage domain) is so large, the transconductance of the HVN1 **11** and HVN2 **12** would be very large as the gate drive voltage changes significantly. Instead of using the conventional method of optimizing the circuit, the present disclosure provides an alternative method to solve the problem by modifying the device structure. The latch stage **50** couples to the input stage **20** for storing a logic state associated with the input signal received from the input stage **20** and generates an output signal at Q and Qb nodes. The pair of cross-coupled NMOS transistors (HVN1 **11** and HVN2 **12**) has at least a transistor characterized in that the drain has a higher RDSon equivalent to an extra embedded resistor **51** connected in series, thereby the transistor has a substantially matched transconductance with the input stage **20** for preventing a discrete realization of a voltage clamp circuit as of FIG. **2** or a substantial increase in transistor area for matching. In an actual implementation, depending on the ratio between the second voltage domain and the first voltage domain, and the ratio between the input stage **20** to the latch stage **50,** the RDSon can be increased by approximately 4 to 20 times. More preferably, both HVN1 **11** and HVN2 **12** have higher RDSon so that there is less chance of error due to wafer-to-wafer variations and die-to-die variations.

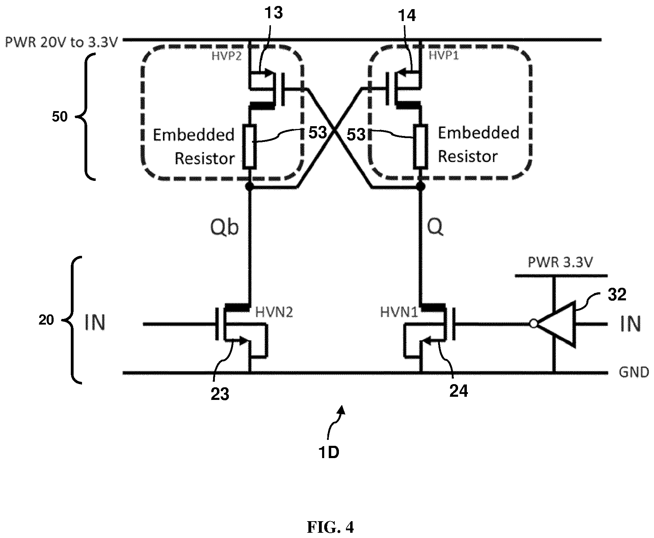

Likewise, the present invention is also applicable to level shifter **ID** using PMOS transistors with the same benefit. As shown in FIG. **4****,** the circuit diagram of a level shifter **ID** having an embedded resistor at the drain of the PMOS transistor is provided. By reversing the NMOS and PMOS of that shown in FIG. **3****,** the input stage **20** is made of NMOS transistors **23, 24** for receiving the input signal **IN** at the gate of HVN2 **23,** and the gate of the HVN1 **24** is driven by the inverted input signal **IN,** which is inverted by the inverter **32.** The inverter **32** is referenced to a high voltage of PWR and a low voltage of GND. The input signal **IN** is also ranged between PWR and GND, which is the first voltage domain. The drains of the two NMOS transistors (HVN2 **23,** HVN1 **24**) are respectively electrically connected to drive a pair of cross-coupled PMOS transistors (HVP2 **13** and HVP1 **14**) at the latch stage **50.** The latch stage **50** couples to the input stage **20** for storing a logic state associated with the input signal received from the input stage **20** and generates an output signal at Qb and Q nodes. The pair of cross-coupled PMOS transistors (HVP2 **13** and HVP1 **14**) has at least a transistor characterized in that the drain has a higher RDSon equivalent to an extra embedded resistor **53** connected in series, thereby the transistor has a substantially matched transconductance with the input stage **20** for preventing a discrete realization of a voltage clamp circuit as of FIG. **2** or a substantial increase in transistor area for matching. More preferably, both HVP2 **13** and HVP1 **14** have higher RDSon so that there is less chance of error due to wafer-to-wafer variations and die-to-die variations.

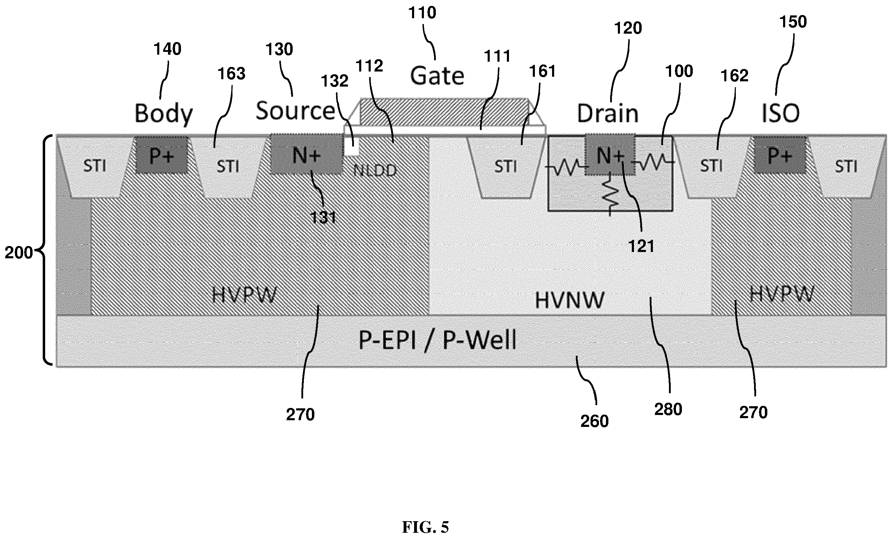

The semiconductor device structure for achieving the higher RDSon is depicted in FIG. **5****,** which is a cross-sectional view of the layout structure of one of the cross-coupled NMOS transistors (HVN1 **11** or HVN2 **12**) implemented in the latch stage **50** with an asymmetric structure. In the preferred embodiment, this structure is implemented in the level shifter of FIG. **3****,** which can be used for simplifying the circuit complexity in a circuit with a wide supply voltage range. Although NMOS is illustrated for demonstrating the present invention, it is obvious to one skilled in the art that a similar structure can be implemented using other MOSFET, for example, PMOS transistor, without departing from the scope and spirit of the present invention.

The semiconductor device includes a gate electrode **110,** a source region **130,** a drain region **120,** and a body region **140,** all formed on a substrate **200** having an EPI layer **260,** and one or more well regions such as HVPW **270** and HVNW **280.**

The illustrated embodiment in FIG. **5** is an NMOS transistor, and so the EPI layer **260** is a P-EPI or P-Well. Formed on the substrate **200,** the body region **140** is tied to the source region **130** and provided in an HVPW **270** to obtain an asymmetric structure. The body region **140** is therefore a P-type, and an ISO region **150** is formed within the substrate for defining the body region **140.** The ISO region **150** may be formed from an HVPW **270.**

The drain region **120** is disposed in a first well region of a first conductive type, which is an HVNW **280** for an NMOS transistor. The source region **130** is disposed in a second well region of a second conductive type different from the first well region, which is an HVPW **270** arranged next to the first well region. Alternatively, when the transistor is a PMOS transistor, the body region **140** and the EPI layer **260** are N-type. The first well region for the drain is an HVPW **270** and the second region for the source is an HVNW **280** instead.

The gate electrode **110** is disposed on a gate insulating layer **111** for forming a conduction channel **112** on the substrate **200** between the source region **130** and the drain region **120.** The gate electrode **110** is electrically connected to the Qb or Q node and the drain terminal of the other transistor in the cross-coupled configuration.

The source region **130** has a source doping region **131** formed vertically below a source terminal (not shown) arranged for connecting or wiring. The source doping region **131** is doped with the first conductive type, e.g., N+ conductivity impurity as shown in the illustrated embodiment for the case of NMOS transistor, with an NLDD **132** extended laterally from the source doping region **131.** The source region **130** and the body region **140** are separated and isolated by at least an STI region **163** on the upper surface of the substrate **200.**

The drain region **120** has a first doping region **121** and a second doping region **100** formed vertically below a drain terminal (not shown) arranged for connecting or wiring. The first doping region **121** is doped with a first conductivity impurity. The second doping region **100** disposed around the first doping region **121** is provided to increase the RDSon at the drain terminal. In particular, the second doping region **100** is doped with a second conductivity impurity different from the first conductivity impurity. There are a few different configurations for realizing the high resistive path at the drain region **120.** Below provided are two typical arrangements and it is apparent to one skilled in the art that other alternatives can be derived based on the same inventive concept.

In the first embodiment, the second doping region **100** has a lower doping concentration of the first conductive type than the first doping region **121.** For example, the first doping region **121** is a heavily doped N+ region while the second doping region **100** is a lightly doped N+ region for NMOS transistor. Similarly, the first doping region **121** is a heavily doped P+ region while the second doping region **100** is a lightly doped P+ region for PMOS transistor.

In the second embodiment, the first doping region has a doping of the first conductive type, and the second doping region **100** has a doping of the second conductive type. For example, the first doping region **121** is an N+ region while the second doping region **100** is a P+ region for the case of NMOS transistor. Similarly, the first doping region **121** is a P+ region while the second doping region **100** is an N+ region for the case of PMOS transistor. With this configuration, the second doping region **100** has a higher RDSon than the first doping region **121,** thereby a high resistive series path is created by the second doping region **100** to mimic an embedded resistor **51** or **53** for the cross-coupled transistor.

On the drain region **120** and at least partially under the gate insulating layer **111,** there is further provided an STI region **161** for forming a drift region near the drain region **120.** The STI region **161** comprises a thin trench preferably formed adjacent to the second doping region **100.** The high resistive series path created by the second doping region **100** is formed between the first doping region **121** and the conduction channel **112** across the STI region **161.**

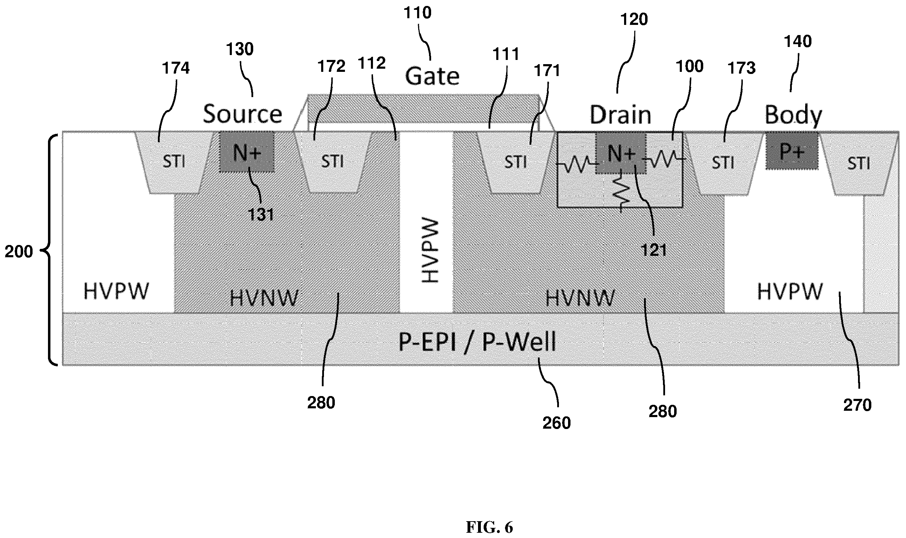

In accordance with a second embodiment, the semiconductor device structure for achieving the higher RDSon can also be implemented in a symmetric structure, as illustrated in the cross-sectional view of the layout structure in FIG. **6****.** For the case of an NMOS transistor, the EPI layer **260** is a P-EPI or P-Well. The body region **140** and the source region **130** are not tied together and separately provided in an HVPW **270** and an HVNW **280** respectively. The drain region **120** is also provided in an HVNW **280.** Therefore, the drain region **120** is disposed in a first well region of the first conductive type, and the source region **130** is disposed in a second well region of the first conductive type, wherein the first and second well regions are separated by a well structure of the second conductive type. In certain embodiments, the source region **130** and the body region **140** are separated and isolated by at least an STI region **174** on the upper surface of the substrate **200,** while the drain region **120** and the body region **140** are also separated and isolated by at least another STI region **173** on the upper surface of the substrate **200.**

With the symmetric structure, the drain region **120** is also formed with a first doping region **121** and a second doping region **100** for increasing the RDSon. The first doping region **121** is doped with a first conductivity impurity. The second doping region **100** disposed around the first doping region **121** is doped with a second conductivity impurity different from the first conductivity impurity. A first STI region **171** is also provided adjacent to the second doping region **100** for forming a drift region near the drain region **120.** Similarly, on the source region **130** and at least partially under the gate insulating layer **111,** there is also provided a second STI region **172** for forming a drift region near the source region **130.**

The description above for the semiconductor device structures in a symmetric structure and an asymmetric structure is provided to the reader in gaining a comprehensive understanding of the use of the second doping region **100** for increasing the RDSon, thereby a high resistive series path can be created to mimic an embedded resistor **51** or **53.** Various changes, modifications, and equivalent implementations will be apparent to one skilled in the art.

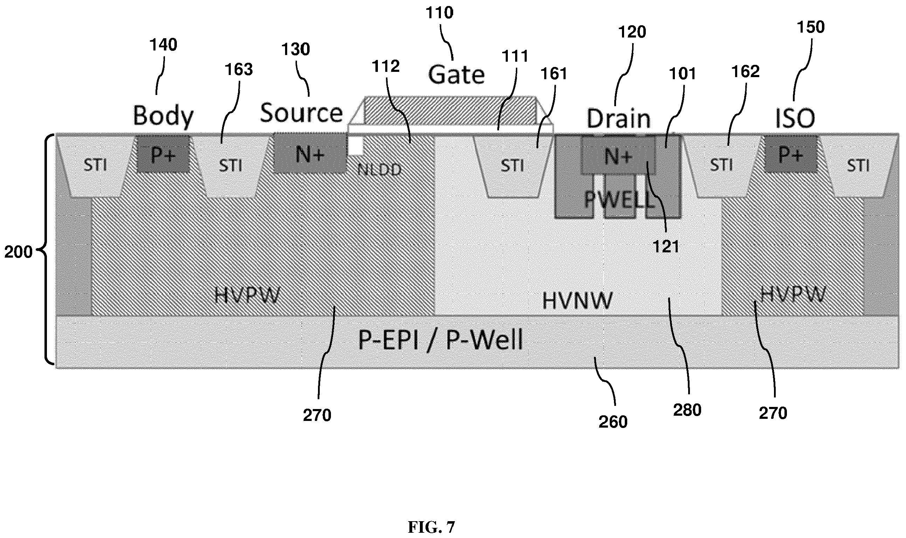

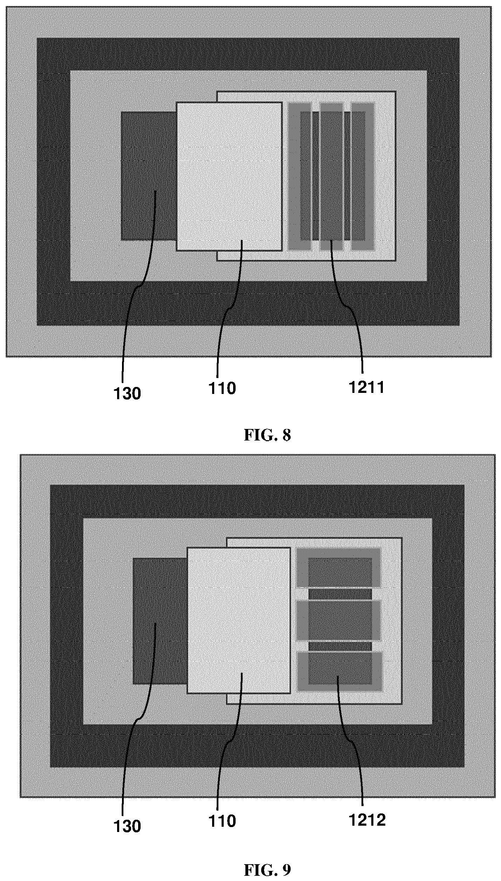

Now refer to FIG. **7****,** an alternative second doping region **101** is illustrated based on an asymmetric structure. The drain region **120** is formed with a first doping region **121** and the alternative second doping region **101** having plural straps doped with a second conductivity impurity for creating a high RDSon than the HVNW **280.** There are a number of possible layout structures for realizing strapping. FIGS. **8-10** show three top views of the layout structures.

FIG. **8** conceptually illustrates a layout structure with plural longitudinal strip-shaped implantations **1211** evenly arranged for increasing the embedded resistance in series with the drain terminal of the drain region **120.**

FIG. **9** conceptually illustrates a layout structure with plural lateral strip-shaped implantations **1212** evenly arranged for increasing the embedded resistance in series with the drain terminal of the drain region **120.**

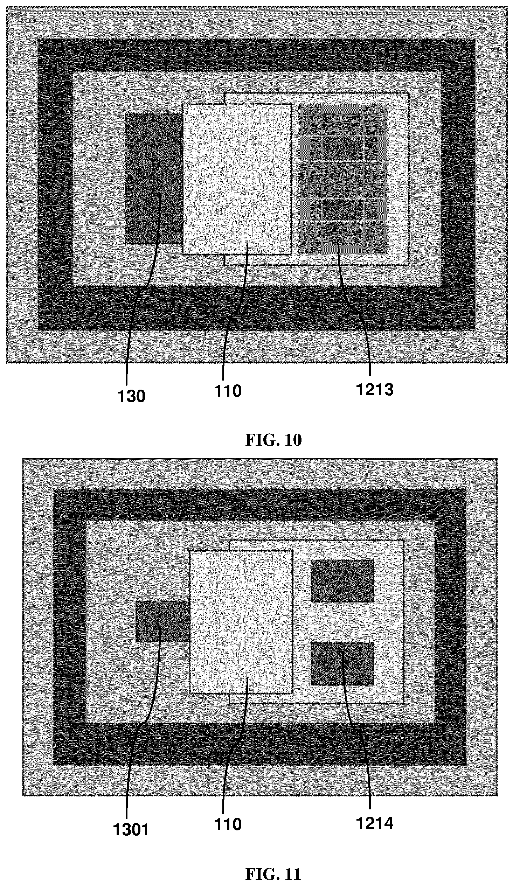

FIG. **10** conceptually illustrates a layout structure with plural checkerboard implantations **1213** arranged for increasing the embedded resistance in series with the drain terminal of the drain region **120.**

FIG. **11** conceptually illustrates a layout structure with a higher resistance by means of minimizing the active area. In this optional embodiment, the drain terminal **1214,** the source terminal **1301,** or both the drain and source terminals have reduced active areas for reducing effective channel width, thereby the high resistive series path can be increased and has a higher resistance. The reduction in active area can be ranged from 10% to 90% so that the resistance can be precisely calculated to serve particular applications. This is against the conventional IC design strategy as the conventional approach is focused on minimizing the RDSon as much as possible.

In certain embodiments, the present invention may be applied to a circuit for a multi-voltage system. The circuit comprises a first system block operating at a first voltage level; a second system block operating at a second voltage level; and a voltage switching module for transmitting a signal from the first system block to the second system block. The voltage switching module comprises a level shifter for translating an input signal of a first voltage domain to an output signal of a second voltage domain. The level shifter comprises an input stage for receiving the input signal; and a latch stage coupled to the input stage for storing a logic state associated with the input signal and generating the output signal. The latch stage comprises at least a transistor characterized in a substantially matched transconductance with the input stage for preventing a discrete realization of a voltage clamp circuit or a significant increase in transistor area. The circuit for the multi-voltage system is characterised in that the transistor is a semiconductor device comprising a source region having a source doping region formed below a source terminal; and a drain region having a first doping region and a second doping region, both formed below a drain terminal. The first doping region is doped with a first conductivity impurity. The second doping region is disposed around the first doping region so as to surround the first doping region, and is doped with a second conductivity impurity. The second doping region has a higher on-resistance than the first doping region, thereby a high resistive series path is created by the second doping region to mimic an embedded resistor.

In a further embodiment, the drain region is disposed in a first well region of a first conductive type, and the source region is disposed in a second well region of a second conductive type different from the first well region; the second doping region has a lower doping concentration of the first conductive type than the first doping region. In certain embodiments, the first well region is a high-voltage N-well and the second well region is a high-voltage P-well; and the first doping region is a heavily doped N+ region, and the second doping region is a lightly doped N+ region. In alternative embodiments, the first well region is a high-voltage P-well and the second well region is a high-voltage N-well; and the first doping region is a heavily doped P+ region, and the second doping region is a lightly doped P+ region.

In a further embodiment, the drain region is disposed in a first well region of a first conductive type, and the source region is disposed in a second well region of a second conductive type different from the first well region; the drain region is disposed in a first well region of a first conductive type, and the source region is disposed in a second well region of a second conductive type different from the first well region. In certain embodiments, the first well region is a high-voltage N-well and the second well region is a high-voltage P-well; and the first doping region is an N+ region, and the second doping region is a P+ region. In alternative embodiments, the first well region is a high-voltage P-well and the second well region is a high-voltage N-well; and the first doping region is a P+ region, and the second doping region is an N+ region.

This illustrates the fundamental structure of the semiconductor device for a circuit with a wide supply voltage range in accordance with the present disclosure. It will be apparent that variants of the above-disclosed and other features and functions, or alternatives thereof, may be combined into many other different methods or apparatuses. The present embodiment is, therefore, to be considered in all respects as illustrative and not restrictive. The scope of the disclosure is indicated by the appended claims rather than by the preceding description, and all changes that come within the meaning and range of equivalency of the claims are therefore intended to be embraced therein.

## Claims

1. A level shifter circuit for translating an input signal of a first voltage domain to an output signal of a second voltage domain, the level shifter circuit comprising:
an input stage (20) for receiving the input signal; and
a latch stage (50) coupled to the input stage (20) for storing a logic state associated with the input signal and generating the output signal, wherein the latch stage (50) comprises at least a transistor **characterized in** a substantially matched transconductance with the input stage for preventing a discrete realization of a voltage clamp circuit or a significant increase in transistor area,
the level shifter circuit being **characterized in that** the transistor is a semiconductor device comprising:
a source region (130) having a source doping region (131) formed below a source terminal; and
a drain region (120) having a first doping region (121) and a second doping region (100), both formed below a drain terminal,
wherein:
the first doping region (121) is doped with a first conductivity impurity;
the second doping region (100) is disposed around the first doping region (121) so as to surround the first doping region (121), and is doped with a second conductivity impurity; and
the second doping region (100) has a higher on-resistance than the first doping region (121), thereby a high resistive series path is created by the second doping region (100) to mimic an embedded resistor (51, 53).

2. The level shifter circuit of claim 1, wherein the drain region (120) is disposed in a first well region of a first conductive type, and the source region (130) is disposed in a second well region of a second conductive type different from the first well region.

3. The level shifter circuit of claim 2, wherein the second doping region (100) has a lower doping concentration of the first conductive type than the first doping region (121).

4. The level shifter circuit of claim 3, wherein:
the first well region is a high-voltage N-well (280) and the second well region is a high-voltage P-well (270); and
the first doping region (121) is a heavily doped N+ region, and the second doping region (100) is a lightly doped N+ region.

5. The level shifter circuit of claim 3, wherein:
The first well region is a high-voltage P-well (270) and the second well region is a high-voltage N-well (280); and
the first doping region (121) is a heavily doped P+ region, and the second doping region (100) is a lightly doped P+ region.

6. The level shifter circuit of claim 2, wherein the first doping region (121) has a doping of the first conductive type; and the second doping region (100) has a doping of the second conductive type.

7. The level shifter circuit of claim 6, wherein:
the first well region is a high-voltage N-well (280) and the second well region is a high-voltage P-well (270); and
the first doping region (121) is an N+ region, and the second doping region (100) is a P+ region.

8. The level shifter circuit of claim 6, wherein:
the first well region is a high-voltage P-well (270) and the second well region is a high-voltage N-well (280); and
the first doping region (121) is a P+ region, and the second doping region (100) is an N+ region.

9. The level shifter circuit of claim 2, wherein the second doping region (100) is formed by plural longitudinal strips (1211), plural lateral strips (1212), or a checkerboard arrangement (1213) of the second conductive type with a higher doping concentration than the first well region.

10. The level shifter circuit of claim 1, wherein the drain region (120) is disposed in a first well region of the first conductive type, and the source region (130) is disposed in a second well region of the first conductive type, thereby the transistor has a symmetrical structure of the source region (130) and the drain region (120).

11. The level shifter circuit of claim 1, wherein the semiconductor device further comprises a gate electrode (110) disposed on a gate insulating layer (111) for forming a conduction channel (112) between the source region (130) and the drain region (120), and wherein the high resistive series path is formed between the first doping region (121) and the conduction channel (112).

12. The level shifter circuit of claim 11, wherein the semiconductor device further comprises a shallow trench isolation region adjacent to the second doping region (100) and at least partially under the gate insulating layer (111).

13. The level shifter circuit of claim 1, wherein the latch stage (50) comprises a pair of cross-coupled transistors.

14. An electronic component, comprising:
a data input module;
a data output module; and
a voltage switching module for transmitting a signal from the data input module to the data output module, wherein the voltage switching module comprises a level shifter for translating an input signal of a first voltage domain from the data input module to an output signal of a second voltage domain for the data output module, and wherein the level shifter comprising:
an input stage (20) for receiving the input signal; and
a latch stage (50) coupled to the input stage (20) for storing a logic state associated with the input signal and generating the output signal, wherein the latch stage (50) comprises at least a transistor **characterized in** a substantially matched transconductance with the input stage (20) for preventing a discrete realization of a voltage clamp circuit or a significant increase in transistor area,
the electronic component being **characterised in that** the transistor is a semiconductor device comprising:
a source region (130) having a source doping region (131) formed below a source terminal; and
a drain region (120) having a first doping region (121) and a second doping region (100), both formed below a drain terminal,
wherein:
the first doping region (121) is doped with a first conductivity impurity;
the second doping region (100) is disposed around the first doping region (121) so as to surround the first doping region (121), and is doped with a second conductivity impurity; and
the second doping region (100) has a higher on-resistance than the first doping region (121), thereby a high resistive series path is created by the second doping region (100) to mimic an embedded resistor (51, 53).

15. The electronic component of claim 14, wherein:
the drain region (120) is disposed in a first well region of a first conductive type, and the source region (130) is disposed in a second well region of a second conductive type different from the first well region;
the second doping region (100) has a lower doping concentration of the first conductive type than the first doping region (121);
the first well region is a high-voltage N-well (280) and the second well region is a high-voltage P-well (270); and
the first doping region (121) is a heavily doped N+ region, and the second doping region (100) is a lightly doped N+ region.

16. The electronic component of claim 14, wherein:
the drain region (120) is disposed in a first well region of a first conductive type, and the source region (130) is disposed in a second well region of a second conductive type different from the first well region;
the second doping region (100) has a lower doping concentration of the first conductive type than the first doping region (121);
the first well region is a high-voltage P-well (270) and the second well region is a high-voltage N-well (280); and
the first doping region (121) is a heavily doped P+ region, and the second doping region (100) is a lightly doped P+ region.

17. The electronic component of claim 14, wherein:
the drain region (120) is disposed in a first well region of a first conductive type, and the source region (130) is disposed in a second well region of a second conductive type different from the first well region;
the first doping region (121) has a doping of the first conductive type; and the second doping region (100) has a doping of the second conductive type;
the first well region is a high-voltage N-well (280) and the second well region is a high-voltage P-well (270); and
the first doping region (121) is an N+ region, and the second doping region (100) is a P+ region.

18. The electronic component of claim 14, wherein:
the drain region (120) is disposed in a first well region of a first conductive type, and the source region (130) is disposed in a second well region of a second conductive type different from the first well region;
the first doping region (121) has a doping of the first conductive type; and the second doping region (100) has a doping of the second conductive type;
the first well region is a high-voltage P-well (270) and the second well region is a high-voltage N-well (280); and
the first doping region (121) is a P+ region, and the second doping region (100) is an N+ region.
